# EUROPEAN PATENT APPLICATION

(11) **EP 4 561 299 A1**
(43) Date of publication of application: **28.05.2025**
(21) Application number: 24212621.7
(22) Date of filing: 13.11.2024
(51) Int. Cl.: H10D 88/00, H10D 84/83, H10D 84/85, H10D 84/01, H10D 30/01, H10D 84/03

(54) **TRANSISTOR DEVICE HAVING SEMICONDUCTOR SPACER, AND FABRICATION METHOD THEREOF**

(30) Priority: 22.11.2023 US 202363602010 P; 23.04.2024 US 202418642910
(71) Applicant: Samsung Electronics Co., Ltd., Suwon-si, Gyeonggi-do 16677 (KR)
(72) Inventor: PARK, Keumseok, San Jose, CA 95134 (US); YUN, Seungchan, San Jose 95134 (US); SEO, Kang-Ill, San Jose, CA 95134 (US)
(74) Representative: Kuhnen & Wacker Patent- und Rechtsanwaltsbüro PartG mbB

(57) **Abstract**

Transistor devices are provided. A transistor device includes a substrate and a transistor stack on the substrate. The transistor stack includes a lower transistor and an upper transistor that is on top of the lower transistor. Moreover, the transistor device includes a semiconductor spacer between the upper transistor and the lower transistor. Related methods of forming transistor devices are also provided.

## Description

### RELATED APPLICATIONS

The present application claims the benefit of U.S. Provisional Patent Application Serial No. 63/602,010, filed on November 22, 2023, entitled *STACKED TRANSISTOR INCLUDING MIDDLE DIELECTRIC INSULATOR AND METHODS OF FORMING THE SAME,* the disclosure of which is hereby incorporated herein in its entirety by reference.

### TECHNICAL FIELD

The present disclosure generally relates to the field of semiconductor devices and, more particularly, to three-dimensional transistor structures.

### BACKGROUND OF THE INVENTION

The size of transistors in integrated circuit (IC) devices has continued to decrease to down-scale logic elements. This has resulted in the development of gate-all-around (GAA) structures such as multi-bridge channel field-effect transistors (MBCFETs^{™}) and nanosheet FETs (NSFETs). Moreover, as technology to increase transistor density has continued to develop, three-dimensional device structures, such as stacked transistors, are under consideration.

A stacked transistor may include a first transistor and a second transistor. The first transistor may be a first type of transistor (e.g., an n-type metal-oxide-semiconductor (NMOS) transistor) and the second transistor may be a second type of transistor (e.g., a p-type metal-oxide-semiconductor (PMOS) transistor). The first and second types of transistors may be complementary to each other, and thus may be part of a complementary metal-oxide-semiconductor (CMOS) IC. The first and second transistors may be stacked in any order (e.g., first on top of second, or second on top of first), thereby resulting in a stack comprising a top/upper device and a bottom/lower device.

### SUMMARY OF THE INVENTION

A transistor device, according to some embodiments herein, may include a substrate and a transistor stack on the substrate. The transistor stack may include a lower transistor and an upper transistor that is on top of the lower transistor. Moreover, the transistor device may include a semiconductor spacer between the upper transistor and the lower transistor.

A transistor device, according to some embodiments herein, may include a substrate and a transistor stack on the substrate. The transistor stack may include a lower transistor and an upper transistor that is on top of the lower transistor. The upper transistor and the lower transistor may each include semiconductor channel layers. The transistor device may include a silicon spacer that separates the upper transistor from the lower transistor. The silicon spacer may be free of nitrogen. Moreover, the transistor device may include a bottom isolation region that is between the substrate and the semiconductor channel layers of the lower transistor.

A method of forming a transistor device, according to some embodiments herein, may include forming a stack of semiconductor layers that alternate with sacrificial gate layers on a substrate. Another sacrificial layer may be between the substrate and a lowermost one of the sacrificial gate layers. Moreover, the method may include replacing the other sacrificial layer with a bottom isolation region. Upper ones of the semiconductor layers may include upper channel layers of an upper transistor. Lower ones of the semiconductor layers may include lower channel layers of a lower transistor. A middle one of the semiconductor layers may separate the upper channel layers from the lower channel layers. The middle one of the semiconductor layers may be thicker, in a vertical direction, than each of the upper channel layers and each of the lower channel layers.

### BRIEF DESCRIPTION OF THE DRAWINGS

FIG. 1A is a schematic block diagram of a transistor stack of a transistor device according to some embodiments herein.
FIG. 1B is a schematic block diagram showing further details of the transistor stack of FIG. 1A.
FIGs. 2A-2P are cross-sectional views illustrating operations of forming the transistor stack of FIG. 1B.
FIG. 3 is a flowchart corresponding to the operations shown in FIGs. 2A-2P.

### DETAILED DESCRIPTION

Pursuant to embodiments herein, transistor devices are provided that include a transistor stack in which an upper transistor and a lower transistor are separated from each other by a semiconductor spacer. The semiconductor spacer may occupy a space that would otherwise be occupied by a middle dielectric isolation (MDI) that includes an insulating material.

An MDI that includes an insulating material may intervene between an upper transistor and a lower transistor of a transistor stack, to separate and electrically isolate the upper transistor and the lower transistor from each other. The MDI, however, may be undesirably thin for a replacement-metal-gate (RMG) process that may be performed for the transistor stack. A thickness of the MDI may be limited by, for example, voids and residues (e.g., silicon germanium residues) that may be generated when replacing a sacrificial layer (e.g., silicon germanium) with the insulating material (e.g., silicon nitride) of the MDI.

Moreover, a critical thickness of the sacrificial layer may make it difficult (if not impossible) to form a bottom dielectric isolation (BDI) for the transistor stack. For example, the sacrificial layer may have a higher concentration of germanium (e.g., 50-55% germanium) than sacrificial gate layers (e.g., 20-25% germanium), and this higher-concentration sacrificial layer may be more difficult to form, more difficult to remove (e.g., more likely to leave a residue), and/or more likely to have defects than the lower-concentration sacrificial gate layers. As a result, it may be difficult to replace higher-concentration sacrificial layers with MDI and BDI regions that are sufficiently thick.

According to embodiments herein, however, a transistor stack may include a semiconductor (rather than dielectric/insulating) spacer between an upper transistor and a lower transistor. The semiconductor spacer may comprise, for example, silicon, and may be free of nitrogen, carbon, oxygen, and germanium. The semiconductor spacer may be formed when forming semiconductor channel layers for the transistor stack, rather than being formed as a replacement for a sacrificial layer. As a result, the semiconductor spacer may be thicker than an MDI that includes an insulating material that replaces a sacrificial layer. Accordingly, voids and residues may be reduced or prevented when forming the semiconductor spacer instead of an MDI that includes an insulating material. Moreover, the absence of a sacrificial layer that precedes the semiconductor spacer may facilitate the formation of a BDI for the transistor stack.

Example embodiments will be described in greater detail with reference to the attached figures.

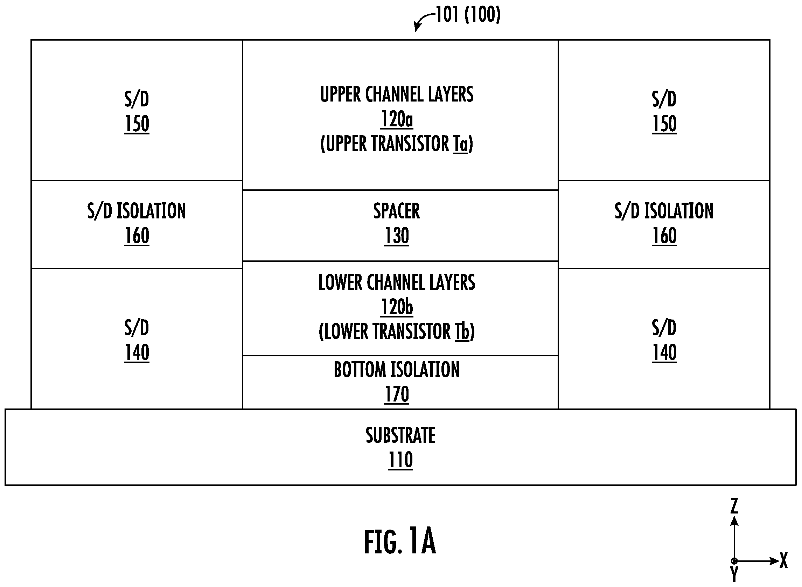

FIG. 1A is a schematic block diagram of a transistor stack 101 of a transistor device 100 according to some embodiments herein. The transistor stack 101 includes a lower transistor Tb having a stack of a plurality of lower semiconductor channel layers 120b and an upper transistor Ta having a stack of a plurality of upper semiconductor channel layers 120a. The channel layers 120a, 120b may comprise, for example, silicon and may be free of germanium and carbon. The lower transistor Tb is between, in a vertical direction Z, the upper transistor Ta and a substrate 110 (e.g., a silicon, or other semiconductor, substrate). A semiconductor spacer 130 may be between, in the vertical direction Z, the upper and lower transistors Ta, Tb. Moreover, a bottom isolation region (e.g., a BDI) 170 may be between, in the vertical direction Z, the lower transistor Tb and the substrate 110.

The lower channel layers 120b of the lower transistor Tb are between, in a first horizontal (i.e., lateral) direction X, a pair of lower source/drain (S/D) regions 140 that are electrically connected to the lower channel layers 120b. The first horizontal direction X and the vertical direction Z may be perpendicular to each other, and a second horizontal (i.e., lateral) direction Y may be perpendicular to each of the first horizontal direction X and the vertical direction Z. Each lower channel layer 120b may be implemented by, for example, a nanosheet or nanowire between the lower S/D regions 140. Likewise, the upper channel layers 120a of the upper transistor Ta may be between, in the first horizontal direction X, a pair of upper S/D regions 150 that are electrically connected to the upper channel layers 120a, and each upper channel layer 120a may be implemented by, for example, a nanosheet or nanowire between the upper S/D regions 150.

In some embodiments, the upper S/D regions 150 may include a different semiconductor material from that of the lower S/D regions 140. As an example, the upper S/D regions 150 may include silicon germanium, and the lower S/D regions 140 may include silicon carbide, or vice versa. In other embodiments, the upper S/D regions 150 may include the same semiconductor material as the lower S/D regions 140.

S/D isolation regions 160 may be between, in the vertical direction Z, the upper S/D regions 150 and the lower S/D regions 140. The S/D isolation regions 160 include an insulating material (e.g., an oxide) that electrically isolates, and physically separates, the upper S/D regions 150 from the lower S/D regions 140. The S/D isolation regions 160 may also be referred to herein as "blocking spacers," as they are spacers between the S/D regions 140, 150 and can block the S/D regions 140, 150 from contacting the spacer 130.

For simplicity of illustration, only one transistor stack 101 is shown in FIG. 1A. According to some embodiments, however, the device 100 may include two, three, four, or more transistor stacks 101.

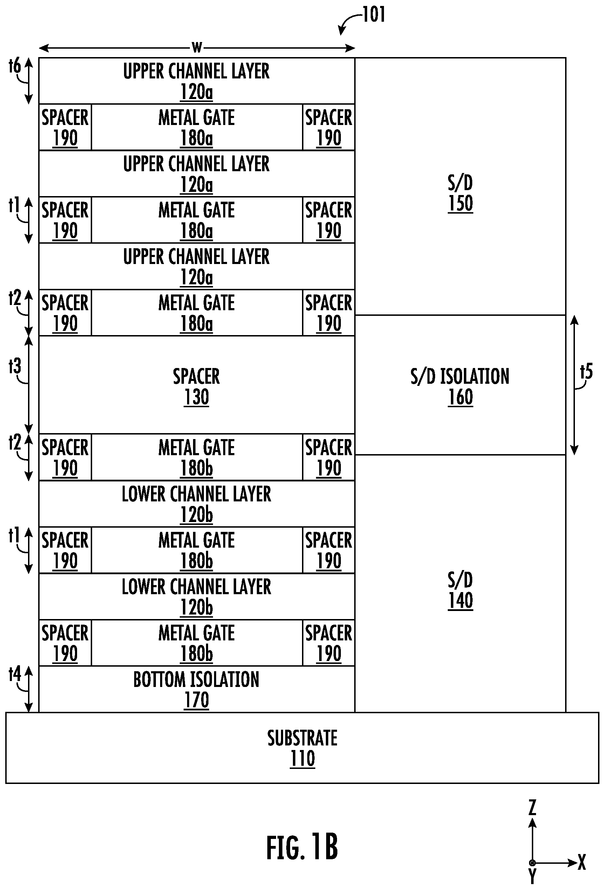

FIG. 1B is a schematic block diagram showing further details of the transistor stack 101. As shown in FIG. 1B, the upper transistor Ta of the transistor stack 101 may include an upper metal gate 180a that is on the upper channel layers 120a. For example, the gate 180a may be between the channel layers 120a. Likewise, the lower transistor Tb of the transistor stack 101 may include a lower metal gate 180b that is on (e.g., between) the lower channel layers 120b.

The gate 180b may be spaced apart from the lower S/D regions 140 in the direction X by insulating spacers 190. The spacers 190 may be on sidewalls of the gate 180b and between, in the vertical direction Z, the lower channel layers 120b. Likewise, the gate 180a may be spaced apart from the upper S/D regions 150 in the direction X by insulating spacers 190, which may be on sidewalls of the gate 180a and between, in the vertical direction Z, the upper channel layers 120a. In some embodiments, the spacers 190 may contact the lower S/D regions 140, the upper S/D regions 150, and sidewalls of the gates 180a, 180b. Sidewalls of the lower channel layers 120b may contact the lower S/D regions 140, and sidewalls of the upper channel layers 120a may contact the upper S/D regions 150.

The bottom isolation region 170 may be between, in the vertical direction Z, the substrate 110 and the channel layers 120b. In some embodiments, the bottom isolation region 170 may be between, in the vertical direction Z, the substrate 110 and the gate 180b. The bottom isolation region 170 includes an insulating material such as silicon nitride.

Moreover, the spacers 190 may comprise, for example, nitrogen (e.g., silicon nitride). The spacers 190 may also be referred to herein as "inner spacers," as they can be situated between nanosheet/nanowire channels within a transistor.

In some embodiments, an uppermost surface of the spacer 130 may contact a lowermost surface of a spacer 190 that is on the gate 180a, and a lowermost surface of the spacer 130 may contact an uppermost surface of a spacer 190 that is on the gate 180b. Moreover, an S/D isolation region 160 may overlap, in the lateral direction X, a portion of a sidewall of the gate 180a (and a portion of the spacer 190 thereon) and a portion of a sidewall of the gate 180b (and a portion of the spacer 190 thereon). Accordingly, an uppermost surface of the S/D isolation region 160 may be at a higher level, in the vertical direction Z, than the uppermost surface of the spacer 130, and a lowermost surface of the S/D isolation region 160 may be at a lower level, in the vertical direction Z, than the lowermost surface of the spacer 130. The S/D isolation region 160 may thus be thicker, in the vertical direction Z, than the spacer 130, and may therefore impede/prevent the S/D regions 140, 150 from contacting the spacer 130.

Some of the spacers 190 may have a thickness t1, in the vertical direction Z, that is thinner than a thickness t2 of others of the spacers 190. For example, ones of the spacers 190 that are immediately adjacent (e.g., in contact with) the spacer 130 may have the thicker thickness t2. As used herein with respect to the spacers 190 and the spacer 130, the term "immediately adjacent" means that no other spacer 190 is between the spacers 190 and the spacer 130. In some embodiments, the thickness t2 may be more than 50% thicker than the thickness t1. As an example, the thickness t1 may be about 8 nanometers (nm), and the thickness t2 may be about 15 nm. Moreover, portions/layers of the gates 180 having the spacers 190 thereon may share the thicknesses of the spacers 190. Accordingly, a lower (e.g., lowermost) portion/layer of the upper gate 180a and an upper (e.g., uppermost) portion/layer of the lower gate 180b may have the thickness t2, and remaining portions/layers of the gates 180a, 180b may have the thickness t1.

The spacer 130 has a thickness t3 that is thicker, in the vertical direction Z, than the each of the thicknesses 11, t2. As an example, the thickness t3 may be greater than 12 nm (or greater than 12.5 nm), greater than 15 nm, greater than 20 nm, or even greater than 30 nm. In some embodiments, the thickness t3 may range from 20-40 nm. In contrast, a conventional MDI including an insulating material that replaces a sacrificial layer may have a thickness of 10-12 nm. The spacer 130 can be thicker than the conventional MDI because the spacer 130 comprises a semiconductor material that can be formed when forming the channel layers 120, rather than being formed as a replacement for a sacrificial layer.

The bottom isolation region 170 has a thickness t4 that may be thinner, in the vertical direction Z, than the spacer 130. For example, the thickness t4 may range from 10-12 nm. According to some embodiments, the thickness t4 may be thicker than the thickness t1.

Each S/D isolation region 160 may be on a respective sidewall of the spacer 130, and may have a thickness t5 that is thicker, in the vertical direction Z, than the thickness t3 of the spacer 130. As a result, the S/D isolation regions 160 can block the S/D regions 140, 150 from contacting the spacer 130. Moreover, the channel layers 120 may have a thickness t6 that is thinner, in the vertical direction Z, than the thickness t3. Accordingly, the spacer 130 may be thicker than each of the channel layers 120. For example, the thickness t6 of each of the channel layers 120 may be about 7 nm, and thus may be thinner than the thickness t1 and less than half (or even less than one-third, less than one-quarter, or less than one-fifth) of the thickness t3.

A width w, in the lateral direction X, of the spacer 130 may be equal to that of each of the channel layers 120. The width w may be, for example, about 20 nm. The width w may be wider than a width of the gates 180, as the spacers 190 may be on sidewalls of the gates 180. In some embodiments, outer sidewalls of the spacers 190 may be collinear, in the vertical direction Z, with sidewalls of the spacer 130 and sidewalls of the channel layers 120.

The upper and lower transistors Ta, Tb may be different types of MOSFETs. For example, the upper and lower transistors Ta, Tb may be PMOS and NMOS transistors, respectively, or vice versa. As an example, PMOS and NMOS transistors may be provided by S/D regions comprising silicon germanium and silicon carbide, respectively. The spacer 130 separates the lower channel layers 120b of the lower transistor Tb from the upper channel layers 120a of the upper transistor Ta. The spacer 130 may comprise, for example, silicon, and may be free of nitrogen and germanium. In some embodiments, the channel layers 120 may comprise the same semiconductor material as the spacer 130. For example, the semiconductor material may comprise crystalline (e.g., monocrystalline) silicon, and may be free of germanium, free of nitrogen (e.g., free of a nitride), free of carbon, and free of oxygen (e.g., free of an oxide).

The spacer 130 and the channel layers 120 are all semiconductor layers in the same transistor stack 101. Accordingly, the lower channel layers 120b may be referred to herein as "lower ones" of the semiconductor layers, the upper channel layers 120a may be referred to herein as "upper ones" of the semiconductor layers, and the spacer 130 may be referred to herein as a "middle one" of the semiconductor layers.

For simplicity of illustration, the lower S/D region 140, upper S/D region 150, and S/D isolation region 160 shown on the left side of FIG. 1A are omitted from view in FIG. 1B, whereas the lower S/D region 140, upper S/D region 150, and S/D isolation region 160 shown on the right side of FIG. 1A are also shown in FIG. 1B.

For further simplicity of illustration, a gate insulation layer is omitted from view in FIG. 1B. It will be understood, however, that a gate insulation layer may extend between each channel layer 120 and a metal gate 180. The gate insulation layer may wrap around each channel layer 120 and may be thinner than the spacers 190.

In some embodiments, channel layers 120 of the upper and lower transistors Ta, Tb may have the same width w. In other embodiments, the lower transistor Tb may be wider, in the direction X, than the upper transistor Ta. The spacer 130, the bottom isolation region 170, the S/D isolation region 160, and/or other features shown in FIG. 1B may thus be implemented in transistor stacks having various shapes.

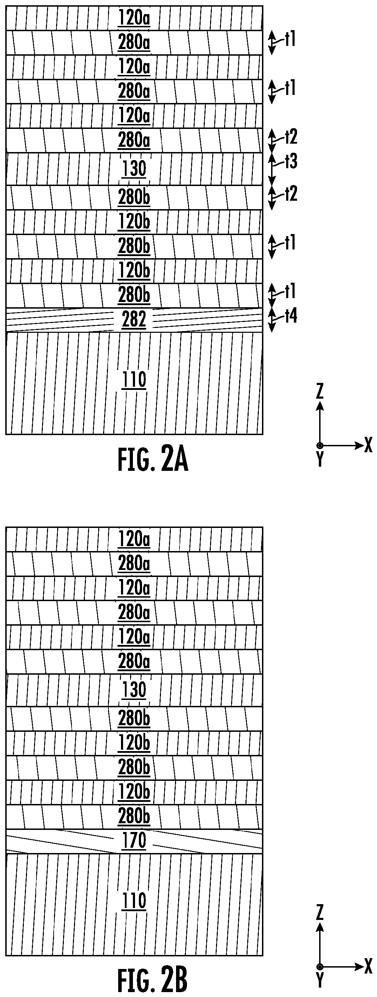

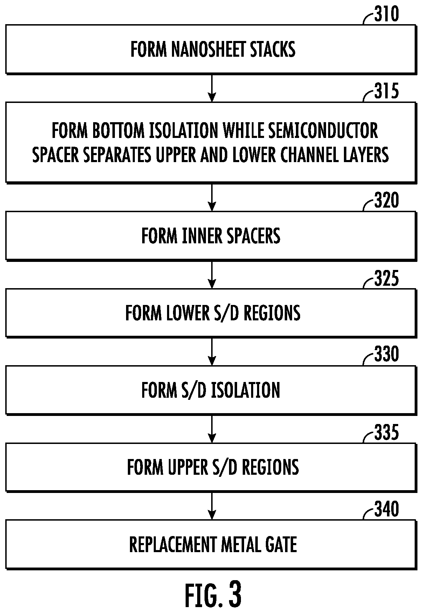

FIGs. 2A-2P are cross-sectional views illustrating operations of forming the transistor stack 101 of FIG. 1B. FIG. 3 is a flowchart corresponding to the operations shown in FIGs. 2A-2P. For simplicity of illustration, elements (e.g., the lower S/D region 140, upper S/D region 150, and S/D isolation region 160 shown on the left side of FIG. 1A) formed to the left of the channel layers 120 are omitted from view in FIGs. 2A-2P. It will be understood, however, that operations performed in FIGs. 2A-2P to the right of the channel layers 120 may simultaneously be performed to the left of the channel layers 120.

As shown in FIGs. 2A and 3, the operations may include forming (Block 310) stacks of semiconductor channel layers 120 on a substrate 110. In some embodiments, the channel layers 120 may be nanosheets, and the stacks may thus be nanosheet stacks. A lower stack comprises channel layers 120b, and an upper stack comprises channel layers 120a. The lower stack is separated from the upper stack by a semiconductor spacer 130, which may be formed simultaneously with, and of the same semiconductor material as, the channel layers 120. Accordingly, the spacer 130 may be formed without taking the place of a sacrificial layer having a high concentration of germanium.

The lower stack, the upper stack, and the spacer 130 may collectively provide a single stack of semiconductor layers that alternate with sacrificial gate layers 280. The sacrificial gate layers 280 include upper sacrificial gate layers 280a and lower sacrificial gate layers 280b. The upper sacrificial gate layers 280a may be alternately stacked on the substrate 110 with the channel layers 120a, and the lower sacrificial gate layers 280b may be alternately stacked on the substrate 110 with the channel layers 120b. The spacer 130 may be between, in the vertical direction Z, an uppermost one of the sacrificial gate layers 280b and a lowermost one of the sacrificial gate layers 280a.

Another sacrificial layer 282 may be between, in the vertical direction Z, the substrate 110 and a lowermost one of the sacrificial gate layers 280b. The other sacrificial layer 282 may have a higher germanium concentration than the sacrificial gate layers 280. For example, the sacrificial gate layers 280 may comprise silicon germanium that is epitaxially grown from the channel layers 120 and has a germanium concentration of 20-25%, and the other sacrificial layer 282 may comprise silicon germanium that is epitaxially grown from the substrate 110 and has a higher germanium concentration (e.g., 50-55% germanium).

According to some embodiments, a lowermost one of the sacrificial gate layers 280b may be epitaxially grown either from a lowermost one of the channel layers 120b or from the other sacrificial layer 282. Moreover, the other sacrificial layer 282 may have a thickness t4 that is thicker than a thickness t1 of some of the sacrificial gate layers 280. For example, the other sacrificial layer 282 may be thicker than the lowermost one of the sacrificial gate layers 280b. In some embodiments, a lowermost surface of the other sacrificial layer 282 may contact an uppermost surface of the substrate 110, and an uppermost surface of the other sacrificial layer 282 may contact a lowermost surface of the lowermost one of the sacrificial gate layers 280b.

The upper stack and the lower stack each form part of the transistor stack 101. The lower channel layers 120b form part of a lower transistor Tb (FIG. 1A) of the transistor stack 101, and the upper channel layers 120a form part of an upper transistor Ta (FIG. 1A) of the transistor stack 101. Multiple transistor stacks 101 may be on the substrate 110 and spaced apart from each other in the direction Y (and/or in the direction X). Accordingly, operations of forming the transistor stacks 101 may include forming multiple stacks of channel layers 120 that are spaced apart from each other in the direction Y (and/or in the direction X).

The channel layers 120 and the spacer 130 are semiconductor layers that comprise, for example, silicon (e.g., crystalline silicon). In a subsequent process/operation, the sacrificial gate layers 280 may be replaced with a metal gate 180 (FIG. 1B). Moreover, the other sacrificial layer 282 may be replaced with a bottom isolation (e.g., BDI) region 170 (FIG. 1B) in a subsequent process/operation. Because a germanium concentration of the sacrificial gate layers 280 may be different from a germanium concentration of the other sacrificial layer 282, the sacrificial gate layers 280 may have an etch selectivity relative to the other sacrificial layer 282. Also, the sacrificial gate layers 280 and the other sacrificial layer 282 may have an etch selectivity with respect to the channel layers 120 and the spacer 130.

As shown in FIGs. 2B and 3, the other sacrificial layer 282 may be removed and replaced (Block 315) with a bottom isolation region 170, which includes an insulating material such as silicon nitride. For example, the other sacrificial layer 282 may be removed by selectively etching the other sacrificial layer 282 relative to the sacrificial gate layers 280, the channel layers 120, and the spacer 130. Accordingly, the bottom isolation region 170 may be formed between (and in contact with) the substrate 110 and a lowermost one of the sacrificial gate layers 280b, while the spacer 130 separates the upper channel layers 120a from the lower channel layers 120b (and while the sacrificial gate layers 280 remain between the channel layers 120). As the bottom isolation region 170 may fully (or at least substantially) replace the other sacrificial layer 282, the bottom isolation region 170 may have the thickness t4 (FIG. 2A) that the other sacrificial layer 282 had.

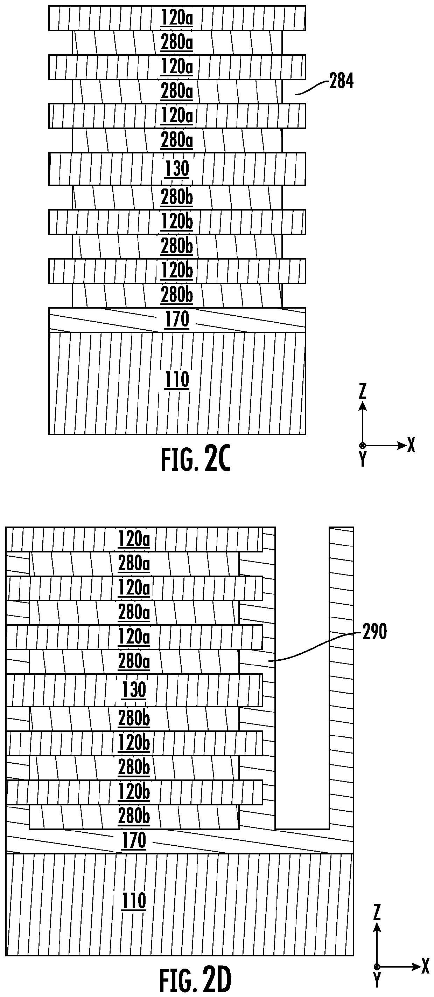

As shown in FIG. 2C, the sacrificial gate layers 280 may be narrowed, in the direction X, to form openings 284 between the channel layers 120. As an example, sidewalls of the sacrificial gate layers 280 may be selectively etched relative to sidewalls of the bottom isolation region 170, the channel layers 120, and the spacer 130.

As shown in FIG. 2D, an insulating layer 290 may be formed in the openings 284, on the substrate 110, and on sidewalls of the channel layers 120. In some embodiments, the insulating layer 290 and the bottom isolation region 170 may include the same insulating material (e.g., silicon nitride).

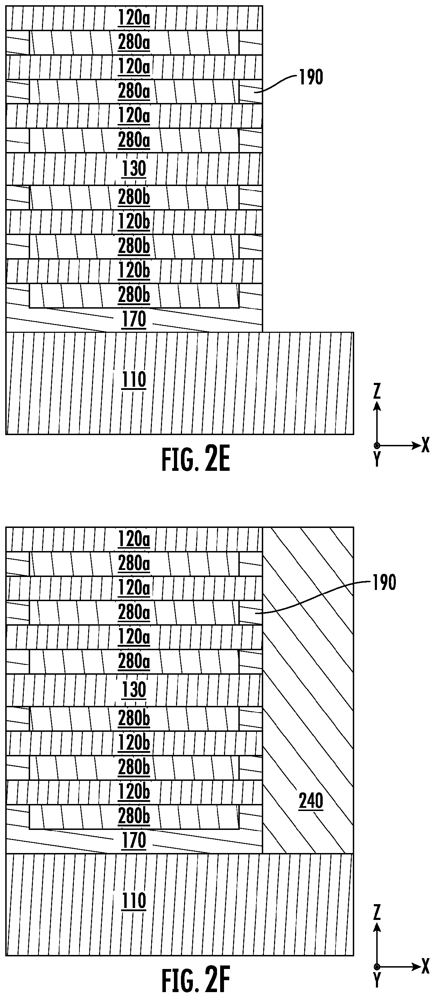

As shown in FIGs. 2E and 3, insulating inner spacers 190 may be formed (Block 320) by selectively removing portions of the insulating layer 290 that are outside of the openings 284. Accordingly, the selective removal may expose sidewalls of the channel layers 120 and a portion of an uppermost surface of the substrate 110. In some embodiments, the selective removal may include vertically, but not laterally, etching the insulating layer 290.

As shown in FIG. 2F, a sacrificial region 240 may be formed on the exposed portion of the substrate 110, on the exposed sidewalls of the channel layers 120, and on sidewalls of the spacers 190. The sacrificial region 240 may comprise an insulating material different from that of the bottom isolation region 170 and the spacers 190. For example, the sacrificial region 240 may comprise an oxide (e.g., silicon oxide).

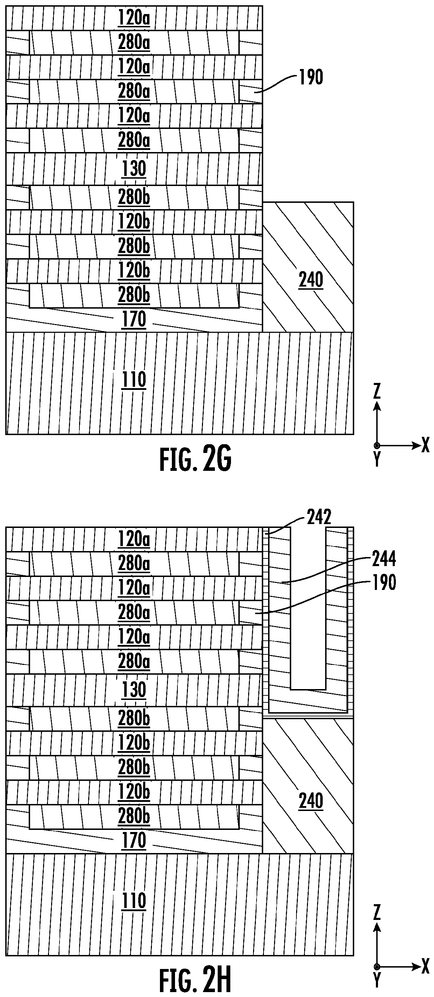

As shown in FIG. 2G, the sacrificial region 240 may be vertically thinned. As an example, the sacrificial region 240 may be etched until its uppermost surface is at a vertical level below that of a lowermost surface of the spacer 130. The sacrificial region 240 may have an etch selectivity relative to the bottom isolation region 170 and the spacers 190. The vertical thinning exposes sidewalls of the upper channel layers 120a, sidewalls of upper ones of the spacers 190, and a sidewall of the spacer 130. In some embodiments, the uppermost surface of the sacrificial region 240 may be at a vertical level of a lower portion of a spacer 190 that is on a sidewall of an uppermost one of the lower sacrificial gate layers 280b. Accordingly, most (e.g., more than 50% or even more than 75%) of a sidewall of the spacer 190 may be exposed.

As shown in FIG. 2H, an insulating layer 242 and an insulating layer 244 may be formed on the uppermost surface of the sacrificial region 240 and on exposed sidewalls of upper ones of the spacers 190 (and an exposed sidewall of the spacer 130) and exposed sidewalls of the upper channel layers 120a. The insulating layer 242 may be between the sacrificial region 240 and the insulating layer 244, and between sidewalls of upper ones of the spacers 190 and the insulating layer 244. Moreover, the insulating layer 242 may have an etch selectivity relative to the spacers 190, the insulating layer 244, and the sacrificial region 240. As an example, the insulating layer 242 may comprise an oxide that is more dense than an oxide of the sacrificial region 240. The insulating layer 244, on the other hand, may comprise the same insulating material (e.g., silicon nitride) as the spacers 190. Accordingly, the insulating layer 242 may protect the spacers 190 when removing vertical portions of the insulating layer 244 in a subsequent operation.

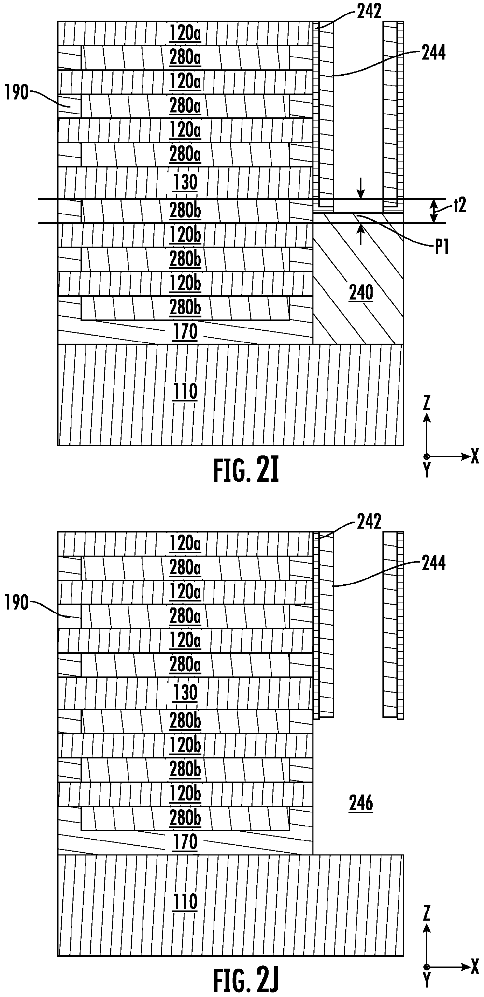

As shown in FIG. 2I, lower, lateral portions of the insulating layers 242, 244 may be removed to expose the uppermost surface of the sacrificial region 240. FIG. 2I also shows an upper portion P1 of the sacrificial region 240 that laterally overlaps a lower portion of a sidewall of the spacer 190 that is on a sidewall of the uppermost one of the lower sacrificial gate layers 280b. The upper portion P1 has a vertical thickness that is thinner than the thickness t2 of the uppermost one of the lower sacrificial gate layers 280b (and the spacer 190 thereon). A lowermost point of the upper portion P1 may be at the same vertical level as a lowermost surface of the uppermost one of the lower sacrificial gate layers 280b, and an uppermost surface of the upper portion P1 may be lower, in the vertical direction Z, than an uppermost surface of the uppermost one of the lower sacrificial gate layers 280b.

As shown in FIG. 2J, the sacrificial region 240 may be removed, thereby forming an opening 246 that exposes a portion of the uppermost surface of the substrate 110, and exposes sidewalls of the lower channel layers 120b. In some embodiments, the sacrificial region 240 may be removed by selective etching relative to the spacers 190, the bottom isolation region 170, and the insulating layers 242, 244.

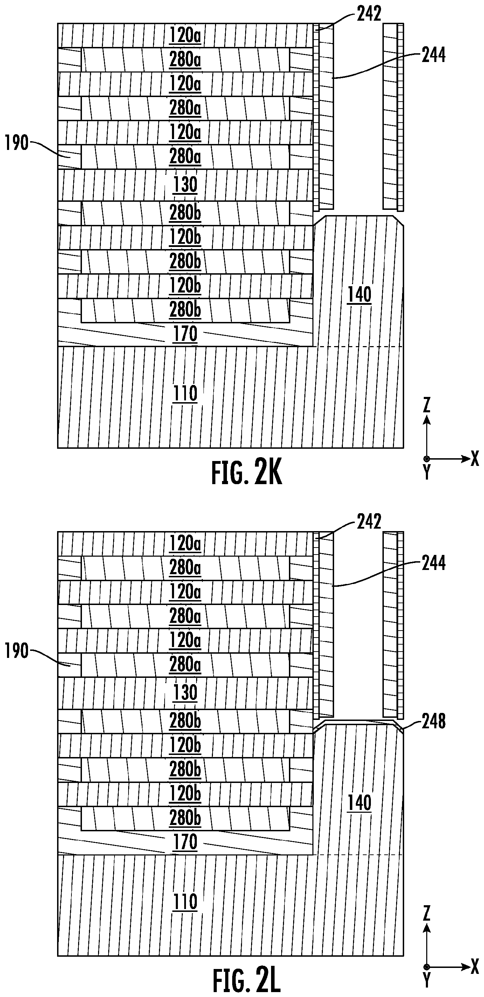

As shown in FIGs. 2K and 3, a lower S/D region 140 is formed (Block 325) in the opening 246. For example, the lower S/D region 140 may be epitaxially grown from the substrate 110 and/or the lower channel layers 120b. The lower S/D region 140 may be on a sidewall of the bottom isolation region 170 and on sidewalls of the lower channel layers 120b. For simplicity of illustration, only one lower S/D region 140 is shown in FIG. 2K. It will be understood, however, that a pair of lower S/D regions 140 may be formed on opposite sides of the lower channel layers 120b.

As shown in FIG. 2L, a thin insulating liner 248 may be formed on an uppermost surface of the lower S/D region 140. The liner 248 may comprise, for example, the same insulating material as the spacers 190 and the insulating layer 244. As an example, the liner 248 may comprise silicon nitride.

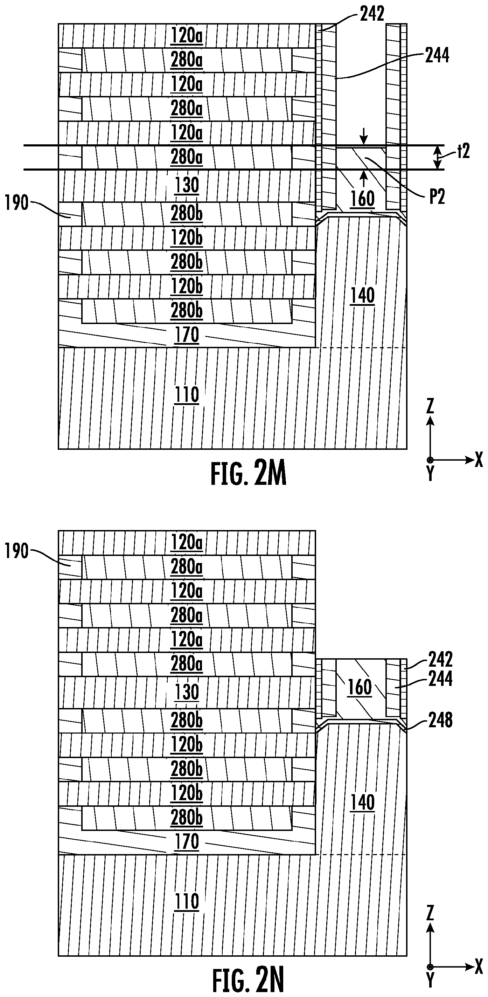

As shown in FIGs. 2M and 3, an S/D isolation region 160 may be formed (Block 330) on top of the liner 248 to laterally overlap (and be vertically thicker than) a sidewall of the spacer 130. The S/D isolation region 160 may comprise, for example, an oxide (e.g., silicon oxide) that is less dense than an oxide of the insulating layer 242. An uppermost surface of the S/D isolation region 160 may be at a vertical level above that of an uppermost surface of the spacer 130. Moreover, a lowermost surface of the S/D isolation region 160 may be at a vertical level below that of a lowermost surface of the spacer 130. The S/D isolation region 160 may thus be thicker, in the vertical direction Z, than the spacer 130.

As an example of the thickness of the S/D isolation region 160, FIG. 2M shows that the S/D isolation region 160 may have an upper portion P2 that laterally overlaps at least a portion of a sidewall of a spacer 190 that is on a sidewall of the lowermost one of the upper sacrificial gate layers 280a. In some embodiments, the upper portion P2 may have a vertical thickness that is thinner than the thickness t2 of the lowermost one of the upper sacrificial gate layers 280a (and the spacer 190 thereon). A lowermost point of the upper portion P2 may be at the same vertical level as a lowermost surface of the lowermost one of the upper sacrificial gate layers 280a, and an uppermost surface of the upper portion P2 may be lower, in the vertical direction Z, than an uppermost surface of the lowermost one of the upper sacrificial gate layers 280a. The upper portion P2 thus does not laterally overlap, in the direction X, the lowermost one of the upper channel layers 120a.

For simplicity of illustration, only one S/D isolation region 160 is shown in FIG. 2M. It will be understood, however, that a pair of S/D isolation regions 160 may be formed on opposite sides of the spacer 130.

As shown in FIG. 2N, vertical portions of the insulating layers 242, 244 that protrude upward beyond the uppermost surface of the upper portion P2 of the S/D isolation region 160 may be removed. For example, vertical portions of the insulating layer 244 may be etched, and then vertical portions of the insulating layer 242 may be etched. The vertical portions of the insulating layer 242 may protect upper ones of the spacers 190 during the etching of the vertical portions of the insulating layer 244. After removing the vertical portions of the insulating layers 242, 244, uppermost surfaces of the insulating layers 242, 244 may be coplanar with the uppermost surface of the S/D isolation region 160.

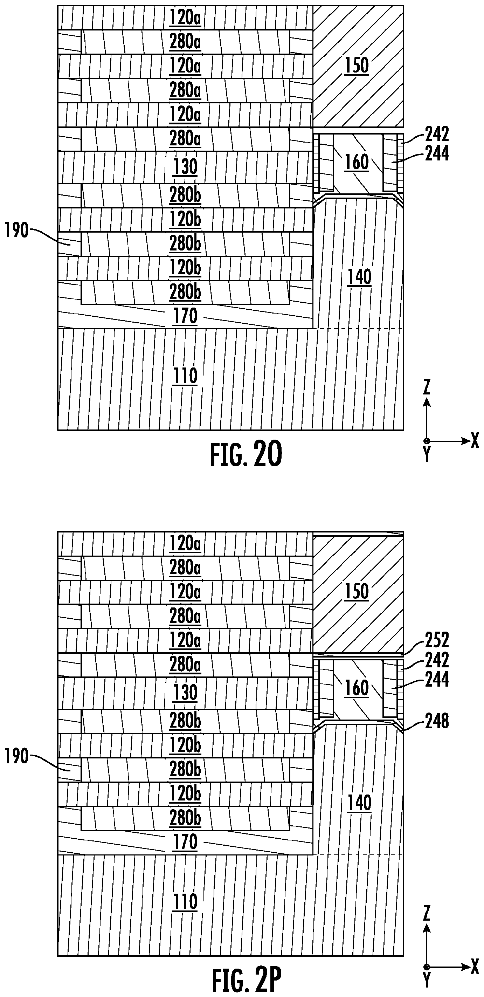

As shown in FIGs. 2O and 3, an upper source/drain region 150 may be formed (Block 335) on top of the S/D isolation region 160. As an example, the upper S/D region 150 may be epitaxially grown from the upper channel layers 120a. For simplicity of illustration, only one upper S/D region 150 is shown in FIG. 2O. It will be understood, however, that a pair of upper S/D regions 150 may be formed on opposite sides of the upper channel layers 120a.

According to some embodiments, the channel layers 120 may comprise silicon, and the lower S/D regions 140 and/or the upper S/D regions 150 may comprise silicon, silicon carbide, or silicon germanium. Moreover, the upper S/D regions 150 may comprise a material different from that of the lower S/D regions 140. For example, the upper S/D regions 150 may comprise silicon germanium, and the lower S/D regions 140 may comprise silicon (without germanium) or silicon carbide.

As shown in FIG. 2P, a thin insulating liner 252 may be formed on a lowermost surface and an uppermost surface of the upper S/D region 150. The liner 252 may comprise, for example, the same insulating material as the spacers 190 and the insulating layer 244. As an example, the liner 252 may comprise silicon nitride. Because the upper portion P2 (FIG. 2M) of the S/D isolation region 160 does not laterally overlap the lowermost one of the upper channel layers 120a, a small gap may exist between the lowermost surface of the upper S/D region 150 and the uppermost surface of the S/D isolation region 160 after the upper S/D region 150 is formed on (e.g., epitaxially grown from) sidewalls of the upper channel layers 120a. The liner 252 may be formed on the lowermost surface of the upper S/D region 150 through that small gap. Moreover, the liner 252 may be a protective liner that impedes/prevents a contact from penetrating the S/D regions 140, 150.

Referring to FIGs. 1B and 3, an RMG process (Block 340) may be performed after forming the S/D regions 140, 150. The RMG process includes removing the sacrificial gate layers 280 and replacing them with metal, thereby forming the metal gates 180a, 180b. The sacrificial gate layers 280 may be removed from between the channel layers 120, as the sacrificial gate layers 280 may have an etch selectivity relative to the channel layers 120. A metal layer may then be formed on the upper and lower stacks of channel layers 120. A gate insulation layer may, according to some embodiments, be formed between the metal layer and the channel layers 120.

In some embodiments, the metal layer may be a first work-function metal (WFM) layer, which may be removed from between the upper channel layers 120a and replaced with a second WFM layer that comprises a different WFM from the first WFM layer. The RMG process may thus comprise a dual WFM (DWFM) process, as the upper transistor Ta and the lower transistor Tb may comprise different WFMs, respectively. For example, the first WFM layer of the lower transistor Tb may comprise aluminum, as the lower transistor Tb may be an NMOS transistor, as the second WFM layer of the upper transistor Ta may comprise titanium nitride, as the upper transistor Ta may be a PMOS transistor. Moreover, tungsten (or another metal) may be formed on the first WFM layer, and then may be formed on the second WFM layer. Accordingly, the lower metal gate 180b may comprise the first WFM layer and tungsten (or another metal), and the upper metal gate 180a may comprise the second WFM layer and tungsten (or another metal).

Transistor devices 100 (FIG. 1A) according to embodiments herein may provide a number of advantages. These advantages include eliminating the need for a silicon-nitride MDI formation process. Instead of forming a silicon-nitride MDI, a semiconductor spacer 130 may be formed when forming channel layers 120 (FIG. 1B). The spacer 130 separates an upper transistor Ta from a lower transistor Tb (FIG. 1A) of a transistor device 100. By using the spacer 130 instead of a silicon-nitride MDI, problems such as silicon-germanium residue (remaining from a sacrificial layer that is replaced by the silicon-nitride MDI) and voids in the MDI can be avoided/mitigated.

Because the spacer 130 is a silicon (e.g., crystalline silicon) layer formed in a process of forming the channel layers 120, the spacer 130 can have a greater thickness t3 (FIG. 1B) than that of a silicon-nitride MDI, which replaces a sacrificial layer (e.g., a high-germanium-concentration sacrificial layer that can make it difficult to form a thick MDI). This greater thickness t3 can help to better separate the upper and lower transistors Ta, Tb from each other. If the spacer 130 is too thick (e.g., thicker than 40 nm or thicker than 50 nm), however, then it may be difficult to replace sacrificial gates 280 (FIG. 2A) with metal gates 180 (FIG. 1B). Accordingly, the thickness t3 of the spacer 130 may range from, for example, 20-40 nm. In some embodiments, the thickness t3 may be selected in consideration of a process window of a DWFM process for forming the metal gates 180.

The spacer 130 can also facilitate forming a bottom isolation region 170 (FIG. 1A), which may otherwise be difficult to form if a silicon-nitride MDI were formed by replacing a sacrificial layer. This is because a critical thickness of the sacrificial layer may make it difficult (if not impossible) to form a BDI. Moreover, it may be desirable for the bottom isolation region 170 to be relatively thick. For example, a thickness t4 (FIG. 1B) of the bottom isolation region 170 may range from 10-12 nm.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. A transistor device comprising:
a substrate;
a transistor stack on the substrate, wherein the transistor stack comprises a lower transistor and an upper transistor that is on top of the lower transistor; and
a semiconductor spacer between the upper transistor and the lower transistor.

2. The transistor device of Claim 1, wherein the upper transistor and the lower transistor each comprise semiconductor channel layers.

3. The transistor device of Claim 2, wherein the semiconductor spacer is thicker, in a vertical direction, than each of the semiconductor channel layers.

4. The transistor device of Claim 2 or 3, further comprising a bottom isolation region that is between the substrate and the semiconductor channel layers of the lower transistor.

5. The transistor device of Claim 4, wherein the bottom isolation region is thinner, in the vertical direction, than the semiconductor spacer.

6. The transistor device of Claim 4 or 5, wherein the bottom isolation region comprises silicon nitride.

7. The transistor device of any one of Claims 2 to 6, wherein the semiconductor spacer has a width, in a lateral direction, that is equal to a width of each of the semiconductor channel layers.

8. The transistor device of any one of Claims 2 to 7, wherein the semiconductor spacer and the semiconductor channel layers comprise the same semiconductor material.

9. The transistor device of Claim 8, wherein the semiconductor material comprises crystalline silicon.

10. The transistor device of Claim 8 or 9, wherein the semiconductor material is free of germanium, free of carbon, free of nitrogen, and free of oxygen.

11. The transistor device of any one of Claims 2 to 10, further comprising:
a source/drain, S/D, isolation region that is on a sidewall of the semiconductor spacer; and
an upper S/D region that is on the S/D isolation region and electrically connected to the semiconductor channel layers of the upper transistor,
wherein the S/D isolation region is thicker, in the vertical direction, than the semiconductor spacer.

12. The transistor device of Claim 11, further comprising a lower S/D region that is electrically connected to the semiconductor channel layers of the lower transistor,
wherein the S/D isolation region separates the lower S/D region from the upper S/D region.

13. The transistor device of Claim 12, further comprising:
a gate between the semiconductor channel layers of the upper transistor; and
an insulating spacer on a sidewall of the gate,
wherein an uppermost surface of the semiconductor spacer contacts a lowermost surface of the insulating spacer, and
wherein an upper portion of the S/D isolation region overlaps, in a lateral direction, the sidewall of the gate and a sidewall of the insulating spacer.

14. The transistor device of Claim 13,
wherein the insulating spacer comprises silicon nitride, and
wherein the semiconductor channel layers comprise nanosheets.

15. The transistor device of any one of the preceding claims, wherein the semiconductor spacer is a silicon spacer that separates the upper transistor from the lower transistor, wherein the silicon spacer is free of nitrogen.
